# EUROPÄISCHE PATENTANMELDUNG

(11) **EP 1 069 784 A2**
(43) Veröffentlichungstag der Anmeldung: **17.01.2001**
(21) Anmeldenummer: 00112983.2
(22) Anmeldetag: 21.06.2000
(51) Int. Cl.: H04Q 1/14

(54) **Variabler Anschlussverteiler**

(30) Priorität: 15.07.1999 DE 29912112 U
(71) Anmelder: NK Networks GmbH, 51063 Köln (DE)
(72) Erfinder: Malinrian, Manfred, 90455 Nürnberg (DE); Obermeyer, Anton, Dipl.-Ing., 92353 Postbauer-Heng (DE); Pfeiler, Christian, Dr., 90475 Nürnberg (DE); Wassmuth, Andreas, Dipl.-Ing., 91154 Roth (DE)
(74) Vertreter: Hübner, Gerd, Dipl.-Phys.

(57) **Zusammenfassung**

Ein variabler Anschlußverteiler für den strukturierten Anschluß von Daten-, Telekommunikations- und Radio/TV-Diensten an ein lokales sternförmiges Leitungsnetz (2) für diese Dienste in Haushalten ist versehen mit
- einem Grundträger (16),
- einer daran angeordneten Leiterplatine (18),
- einer bestimmten Anzahl von darauf montierten Ausgangs-Anschlußelementen (21) für die abgehenden Daten- und Telekommunikations-Leitungen (3) des Netzes, und
- einer entsprechenden Anzahl von ebenfalls auf der Leiterplatine (18) montierten Eingangs-Anschlußbuchsen (27, 28), die jeweils den Daten- bzw. Radio/TV-Diensten zugeordnet und mit den Ausgangs-Anschlußelementen (21) über Leiterbahnen (29) auf der Leiterplatine (18) verbunden sind, wobei die Eingangs-Anschlußbuchsen (27, 28) für Datendienste einerseits und Telekommunikationsdienste andrerseits in räumlich getrennten Gruppen (25, 26) auf der Leiterplatine (18) angeordnet sind.

## Beschreibung

Die Erfindung betrifft einen variablen Anschlußverteiler für den strukturierten Anschluß von Daten-, Telekommunikations- und Radio/TV-Diensten an ein lokales, sternförmiges Leitungsnetz für diese Dienste in Haushalten.

Zum Hintergrund der Erfindung ist festzuhalten, daß die moderne Daten- und Telekommunikations-Technik in der Büro- und Industrieumgebung zu den grundlegenden Infrastrukturelementen gehört und in unterschiedlichster Ausprägung umgesetzt werden. Hier finden z.B. kombinierte Leitungsnetze für Datenübertragungs- und Telekommunikationsdienste bereits umfassende Verbreitung. Die dabei existierenden Industriestandards sehen beispielsweise 19-Zoll-Racks für sogenannte Hubs, Patchfelder u. dgl. zum Aufbau von strukturierten Netzen vor. Die Verbindung zwischen Telekommunikationsanlagen und Netz-Servern findet dann von den Schnittstellen über Patchkabel zu entsprechenden Anschlüssen am Patchfeld statt. Die einzelnen Anschlußbuchsen der Patchfelder können über Programmierung den jeweiligen Diensten zugeordnet werden, wobei keine bestimmte Ordnung der schlicht aneinandergereihten Anschlußbuchsen des Patchfeldes vorgesehen ist.

Aufgrund der vorstehenden Umstände ist die gängige Büro- und Industrietechnik auf diesem Gebiet zwar einerseits sehr variabel, andererseits jedoch vergleichsweise unübersichtlich, was ihre Anwendung im privaten Bereich, also in Wohnhäusern und Wohnungen erfahrungsgemäß schwierig macht.

Ausgehend von dieser Problematik liegt der Erfindung daher die Aufgabe zugrunde, einen variablen Anschlußverteiler für den strukturierten Anschluß von verschiedenen Diensten an ein lokales sternförmiges Leitungsnetz in Privathaushalten zu schaffen, der sehr übersichtlich und einfach anschließbar ist.

Diese Aufgabe wird durch die im Anspruch 1 angegebenen Merkmale gelöst. Kernpunkt ist dabei einerseits, daß Zur-Verfügung-Stellen von auf einer Leiterplatine vormontierten Eingangs-Anschlußbuchsen, die über Leiterbahnen auf der Leiterplatine mit den entsprechenden Ausgangs-Anschlußelementen verbunden sind. Letztere stellen die Schnittstellen zu den vom Verteiler abgehenden Daten- und Telekommunikationsleitungen des Netzes dar. Andererseits sind die Eingangs-Anschlußbuchsen entsprechend der Zugehörigkeit zu dem von ihnen versorgten Dienst in räumlich getrennten Gruppen auf der Platine angeordnet, so daß sehr augenfällig und für jeden interessierten Laien verständlich allein durch Setzen von Patchkabeln zwischen den jeweiligen Eingangs-Anschlußbuchsen und der zugehörigen Anschlußbuchse des jeweiligen Schnittstellen-Endgerätes eine korrekte Verbindung und Verkabelung herstellbar ist.

Ein weiterer Vorteil des erfindungsgemäßen Anschlußverteilers liegt darin, daß bei späteren Aufrüstungen des Gesamtsystems, beispielsweise bei einer Erhöhung der Anzahl der von einer ISDN-Anlage bedienten Telefonapparate, lediglich weitere Patchkabel zwischen der Anlage und dem Anschlußverteiler gesteckt werden müssen.

Zusammenfassend werden also die physikalischen Übertragungsstrecken eines lokalen Leitungsnetzes mit Hilfe des erfindungsgemäßen Anschlußverteilers auf standardisierte, einfach erkennbare Anschlüsse für die jeweiligen Dienste aufgeteilt, wobei Standard-Stecksysteme und Standard-Steckerbelegungen problemlos berücksichtigt werden können. Dies bringt eine optimale Montagefreundlichkeit und spätere Erweiterbarkeit der damit versehenen Anlagen und Heimnetze mit sich.

Bevorzugte Weiterbildungen der Erfindung sind den Unteransprüchen entnehmbar. Weitere Merkmale, Einzelheiten und Vorteile ergeben sich ferner aus der folgenden Beschreibung eines Ausführungsbeispiels der Erfindung anhand der beigefügten Zeichnungen. Es zeigen:
- Fig. 1: ein schematisches Diagramm eines sternförmigen Wohnungsleitungsnetzes und des dabei eingesetzten Anschlußverteilers,
- Fig. 2: eine schematische Draufsicht auf den Anschlußverteiler mit zugeordneten Schnittstellen-Endgeräten, und
- Fig. 3: einen Stromlaufplan der Leiterbahnverbindungen zwischen Eingangs-Anschlußbuchsen und Ausgangs-Anschlußelementen auf der Leiterplatine des Anschlußverteilers.

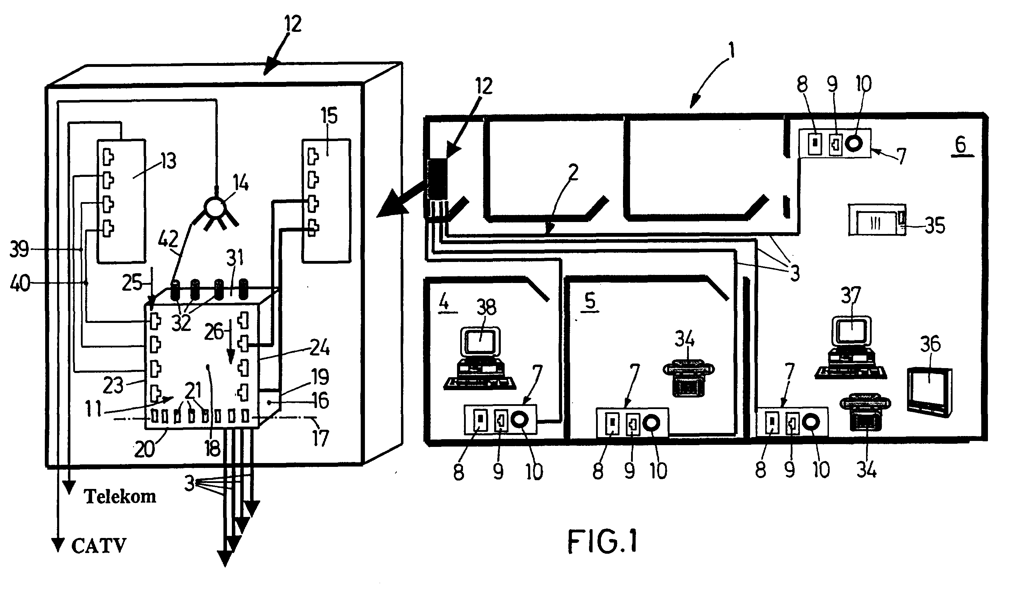

Wie aus Fig. 1 deutlich wird, ist für eine Wohnung 1 eines Privathaushalts ein sternförmiges Leitungsnetz 2 mit Leitungen 3 in einzelne Räume 4, 5, 6 vorgesehen. Die Leitungen 3 enden jeweils in kombinierten Wanddosen 7, die standardisierte Anschlußbuchsen 8, 9, 10 für Telefon (TAE-Buchse), Datenübertragung (Western-Buchse) und Kabel-Radio/TV (Koax-Buchse) aufweisen.

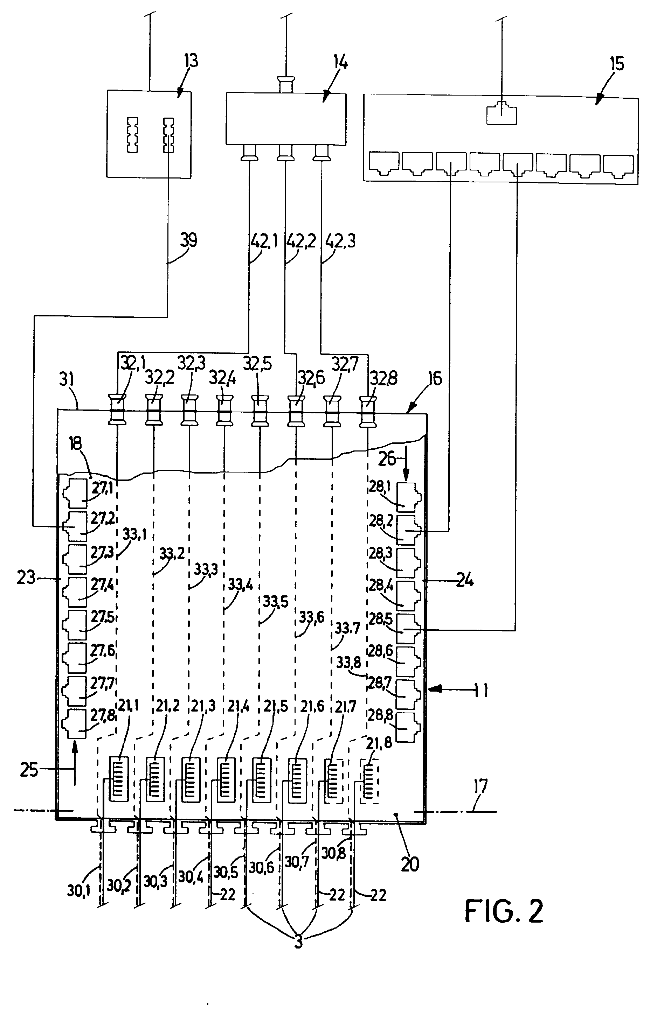

Die Leitungen 3 selbst sind als Doppelstrang-Leitungen (22, 30 in Fig.2) ausgeführt, wobei ein Strang aus einem geschirmten Koaxial-Kabel für den Radio-TV-Dienst gebildet ist. Der zweite Strang besteht aus einem mehradrigen Kabel mit mehreren verdrillten Leiterpaaren (Twisted-Pair-Kabel) für Daten- und ISDN-Anwendungen und entspricht mindestens dem Standard "Cat.5", ist also bis zu einer Übertragungsfrequenz von 100 MHz geeignet. Die einzelnen verdrillten Leiterpaare sind dabei getrennt geschirmt, so daß sogenanntes "Cable Sharing" zwischen Datenübertragungs- und Telekommunikationsdiensten möglich ist. Üblicherweise benutzt ein Dienst dabei zwei Leiterpaare, nämlich eines für jede Übertragungsrichtung.

Wie aus Fig. 1, rechter Teil deutlich wird, führen die Leitungen 3 sternförmig zu einem variablen Anschlußverteiler 11, der mit weiterenKomponenten in einem Unterputz-Hausinstallationskasten 12 montiert ist. Bei diesen Komponenten handelt es sich beispielsweise um eine ISDN-Anlage 13, die am Telekommunikationsnetz "Telekom" angeschlossen ist, einen sogenannten CATV-Splitter 14 zum Verzweigen eines vom Kabelanschluß CATV hereingeführten Radio-TV-Signals und ein Hub-Schnittstellengerät 15, das mit einem File-Server (nicht gezeigt) für das durch das Leitungsnetz 2 und die daran angeschlossenen PC's gebildete PC-Netzwerk verschaltet ist.

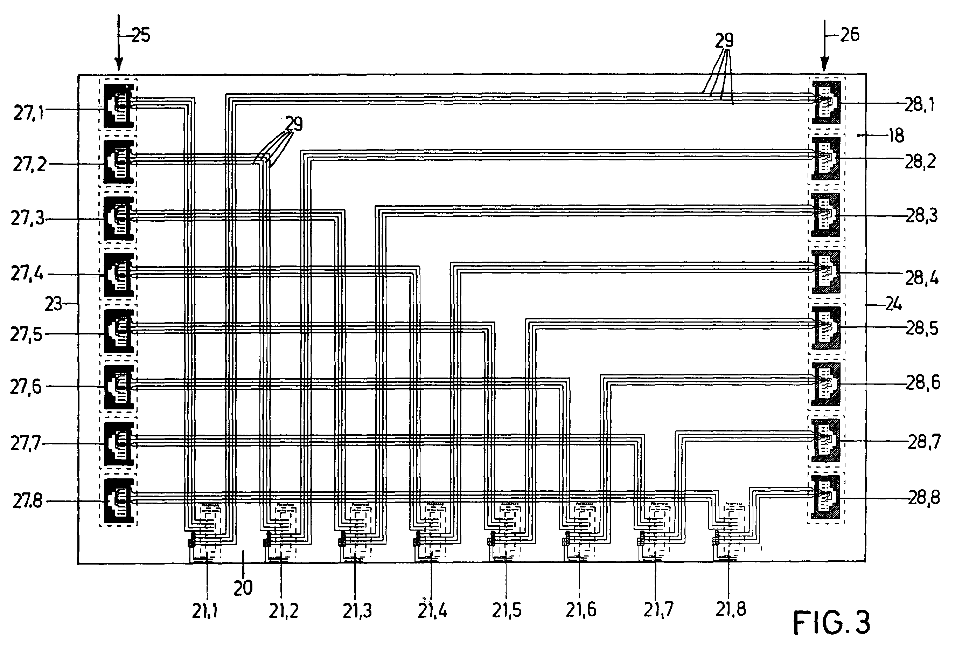

Die in Fig. 1 höchst schematisch dargestellte Konstruktion des Anschlußverteilers 11 ist anhand von Fig. 2 und 3 näher zu erläutern. Grundsätzlich weist der Anschlußverteiler 11 einen rahmenförmigen Grundträger 16 auf, in dem eine in nicht näher dargestellter Weise um eine Achse 17 schwenkbare Leiterplatine 18 mit Abstand zur rückseitigen Kante 19 des Grundträgers 16 (Fig. 1) gelagert ist. Auf dieser Leiterplatine 18 sind entlang eines Seitenrandes 20 Ausgangs-Anschlußelemente 21.1 bis 21.8 in Form von jeweils 8-poligen LSA-plus-Schneidklemmen-Anschlüssen angeordnet. An diesen jeweils acht Polen der Anschlußklemmen 21.1 bis 21.8 sind jeweils die einzelnen Adern der vier verdrillten Leiterpaare des einen Leitungsstranges 22 der Leitungen 3 nach einer definierten Belegung dauerhaft angeschlossen.

An den beiden rechtwinklig zum Seitenrand 20 verlaufenden Seitenrändern 23, 24 liegen jeweils linear in einer Reihe 25 bzw. 26 angeordnet EingangsAnschlußbuchsen 27.1 bis 27.8 für den Telekommunikationsdienst, also beispielsweise für eine ISDN-Anlage 13, sowie Eingangs-Buchsen 28.1 bis 28.8 für einen Datenübertragungsdienst. Wie aus Fig. 3 schematisch deutlich wird, sind die jeweiligen Eingangs-Buchsen 27.1 und 28.1 nach einer definierten Belegung mit den einzelnen Polen der zugeordneten Ausgangs-Anschlußklemme 21.1 über entsprechende Leiterbahnen 29 verbunden, die durch eine z.B. mit 5 Leiterbahn-Ebenen versehene Platinenkonstruktion realisierbar sind. Dies trifft analog für alle weiteren Eingangs-Buchsen 27.2 bis 28.8 zu. Alle Eingangs-Buchsen 27.1 bis 28.8 sind als Western-Buchsen ausgebildet.

Für den Anschluß der Koaxial-Stränge 30 der einzelnen Leitungen 3 sind an dem Grundträger-Seitenteil 31, das zwischen den beiden Seitenrändern 23, 24 der Leiterplatine 18 verläuft, jeweils Koaxial-Eingangs-Buchsen 32.1 bis 32.8 montiert, von denen Koax-Kabel 33.1 bis 33.8 zu der Ausgangsseite des Anschlußverteilers 11 führen. Diese Koax-Kabel 33.1 bis 33.8 laufen unter der Leiterplatine hindurch und gehen in einem Stück in den entsprechenden Koaxial-Strang 30.1 bis 30.8 der Doppelstrang-Leitungen 3 des Leitungsnetzes 2 über.

Anhand von Fig. 1 ist die einfache und überschaubare Endmontage und Verkabelung eines Heimnetzes mit Hilfe des erfindungsgemäßen Anschlußverteilers 11 zu erläutern:

Grundsätzlich wird die Wohnung 1 mit dem Leitungsnetz 2 ausgerüstet, dessen Leitungen 3 in dem vormontierten Anschlußverteiler 11 enden. Der jeweilige Wohnungsbesitzer schafft nun beispielsweise eine ISDN-Anlage 13 für zwei Telefone 34 und ein Faxgerät 35 an, die in den Räumen 4, 5 der Wohnung 1 betrieben werden sollen. Ferner wird ein Fernsehgerät 36 im Raum 6 eingesetzt. Schließlich soll ein aus zwei Personalcomputern 37, 38 bestehendes PC-Netzwerk realisiert werden. Nach Installation der entsprechenden Schnittstellen-Endgeräte, nämlich der ISDN-Anlage 13, des CATV-Splitters 14 und des Hubs 15 genügt es, zwei Patchkabel 39 zwischen die ISDN-Anlage 13 und die entsprechenden Eingangs-Buchsen 27 für die beiden Räume 5, 6 zu stecken. Desgleichen genügen zwei Patchkabel 40 zur Verbindung der beiden Personalcomputer 37, 38 über den Hub 15. Zur Zuführung des CATV-Signals vom Haus-Kabelanschluß CATV über den Splitter 14 reicht es, ein Koax-Kabel 42.1 zwischen den CATV-Splitter 14 und die entsprechenden Koax-Eingangs-Buchse 32 für den Raum 6 am Anschlußverteiler 11 zu setzen.

Sollen beispielsweise zu einem späteren Zeitpunkt auch in den Räumen 4 und 5 jeweils Fernsehgeräte betrieben werden, so genügt es, zwischen den CATV-Splitter 14 und die entsprechenden Koax-Eingangs-Buchsen 32 weitere Koax-Kabel 42.2, 42.3 zu setzen, wie dies in Fig. 2 angedeutet ist.

## Patentansprüche

1. Variabler Anschlußverteiler für den strukturierten Anschluß von Daten-, Telekommunikations- und Radio/TV-Diensten an ein lokales sternförmiges Leitungsnetz (2) für diese Dienste in Haushalten mit
- einem Grundträger (16),
- einer daran angeordneten Leiterplatine (18),
- einer bestimmten Anzahl von darauf montierten Ausgangs-Anschlußelementen (21) für die abgehenden Daten- und Telekommunikations-Leitungen (3) des Netzes, und
- einer entsprechenden Anzahl von ebenfalls auf der Leiterplatine (18) montierten Eingangs-Anschlußbuchsen (27, 28), die jeweils den Daten- bzw. Radio/TV-Diensten zugeordnet und mit den Ausgangs-Anschlußelementen (21) über Leiterbahnen (29) auf der Leiterplatine (18) verbunden sind, wobei die Eingangs-Anschlußbuchsen (27, 28) für Datendienste einerseits und Telekommunikationsdienste andrerseits in räumlich getrennten Gruppen (25, 26) auf der Leiterplatine (18) angeordnet sind.

2. Verteiler nach Anspruch 1, **dadurch gekennzeichnet, daß** die Eingangs-Anschlußbuchsen (27) für Telekommunikationsdienste in einer ersten Reihe (25) an einem Seitenrand (23) der Leiterplatine (18) und die Eingangs-Anschlußbuchsen (28) für Datendienste in einer zweiten Reihe (26) an dem gegenüberliegenden Seitenrand (24) der Platine (18) angeordnet sind.

3. Verteiler nach Anspruch 1 oder 2, **dadurch gekennzeichnet, daß** die Ausgangs-Anschlußelemente (21) durch Schneidklemmenanschlüsse gebildet sind.

4. Verteiler nach einem der Ansprüche 1 bis 3, **dadurch gekennzeichnet, daß** an den Ausgangs-Anschlußelementen (21) kombinierte Leitungen (3) mit mehreren verdrillten Leiterpaaren angeschlossen sind, von denen vorzugsweise jeweils zwei einem bestimmten Dienst zugeordnet ist.

5. Verteiler nach einem der Ansprüche 1 bis 4, **dadurch gekennzeichnet, daß** die Eingangs-Anschlußbuchsen (27, 28) durch RJ45- oder Western-Buchsen gebildet sind.

6. Verteiler nach einem der Ansprüche 1 bis 5, **dadurch gekennzeichnet, daß** am Grundträger (16) Koaxial-Eingangsbuchsen (32) zum Anschluß von Eingangskabeln (42) für Radio/TV-Dienste angeordnet sind, wobei unter der Leiterplatine (18) durchgeschleifte Koaxialkabel (33) zu den jeweiligen Koaxialkabeln (30) des lokalen Netzes führen.

7. Verteiler nach Anspruch 5 oder 6, **dadurch gekennzeichnet, daß** die Koaxial-Eingangsbuchsen (32) an dem Seitenteil (31) des Grundträgers (16) angeordnet sind, der zwischen den beiden die Eingangs-Anschlußbuchsen (27, 28) für die Daten- und Telekommunikations-Dienste tragenden Seitenränder (23, 24) der Leiterplatine (18) verläuft.

8. Verteiler nach Anspruch 7, **dadurch gekennzeichnet, daß** die durchgeschleiften Koaxialkabel (33) in einem Stück in die Koaxialkabel (30) des lokalen Netzes übergehen.

9. Verteiler nach einem der Ansprüche 1 bis 7, **dadurch gekennzeichnet, daß** der Verteiler gemeinsam mit Schnittstellen-Endgeräten (13, 14, 15) der Daten-, Telekommunikations- und Radio/TV-Dienste in einem Hausinstallationskasten (12) montierbar ist.

10. Verteiler nach einem der Ansprüche 1 bis 9, **dadurch gekennzeichnet, daß** die Leiterplatine (18) schwenkbar am Grundträger (16) montiert ist.
